# EUROPEAN PATENT APPLICATION

(11) **EP 4 646 076 A1**
(43) Date of publication of application: **05.11.2025**
(21) Application number: 24173435.9
(22) Date of filing: 30.04.2024
(51) Int. Cl.: H10K 30/30, H10K 30/85, H10K 30/86, H10K 39/30, H10K 39/00, H10K 85/20, H10K 30/57

(54) **LIGHT HARVESTING COMPONENT**

(71) Applicant: CREDOXYS GmbH, 01187 Dresden (DE)
(72) Inventor: DOROK, Sascha, 01187 Dresden (DE)

(57) **Abstract**

The invention relates to a light-harvesting component, preferably an organic photovoltaic component or an organic photoactive sensor, comprising a first substrate, an electrode, a counterelectrode, and an organic layer system positioned between the electrode and the counterelectrode comprising at least a first photoactive layer. As an advantage, the inventive light harvesting component shows good properties, e.g. a high conductivity of the charge transport layers and a low absorption of the charge carrier transport layers. The invention further relates to an electricity generating window and the use of a light harvesting component.

## Description

### Background of the invention

The invention relates to a light-harvesting component, preferably an organic photovoltaic component or an organic photoactive sensor, comprising a first substrate, an electrode, a counterelectrode, and an organic layer system positioned between the electrode and the counterelectrode comprising at least a first photoactive layer. As an advantage, the inventive light harvesting component shows good properties, e.g. a high conductivity of the charge transport layers and a low absorption of the charge carrier transport layers. The invention further relates to an electricity generating window and the use of a light harvesting component.

Light harvesting components and especially organic photovoltaic components have been used to convert solar energy which is irradiated onto the component into electricity. As these components comprise several organic layers, the organic nature of the materials has to be taken into account.

Unlike inorganic semiconductors, organic semiconductors have a very low intrinsic charge carrier density. To achieve good semiconductor properties, organic semiconductor matrix materials, especially charge carrier transport matrix materials, are therefore usually doped. This especially applies to charge carrier transport layers, especially to electron transport layers and hole transport layers. Charge carrier transport matrix materials can be strongly influenced in terms of their electrical conductivity by such a doping. The charge carrier transport layers can comprise either matrix materials with electron donor properties (p-type conductors) or matrix materials with electron acceptor properties (n-type conductors).

For n-doping, strong electron donors (n-dopants) are used to transfer an electron to the LUMO (lowest unoccupied molecular orbital) of the semiconductor matrix (n-doping), resulting in a free electron on the matrix (SOMO - singly occupied molecular orbital). For p-doping, strong electron acceptors (p-dopants) are used to remove an electron from the HOMO (highest occupied molecular orbital) of the semiconductor matrix (p-doping), leaving a hole.

However, there is still the aim to enhance light havesting components with regard to their efficiency and to improve other properties.

It is an object of the present invention to overcome the disadvantages of the state of the art, in particular to improve the properties of light harvesting components such as organic photovoltaic components and organic photoactive sensors.

### Summary of the invention

A first object of the invention is a light-harvesting component, preferably an organic photovoltaic component or an organic photoactive sensor, comprising a first substrate, an electrode, a counterelectrode, and an organic layer system, wherein the organic layer system is positioned between the electrode and the counterelectrode. The organic layer system comprises at least a first photoactive layer, wherein the first photoactive layer comprises a first acceptor material and a first donor material.

The organic layer system comprises at least a first charge carrier transport layer, wherein the first charge carrier transport comprises a first charge carrier transport matrix material and at least a concentration of 0.1 vol.%, preferably at least 0.5 vol.%, of a first dopant, wherein the first dopant is an anti-aromatic compound.

Preferabyl, the light-harvesting component, preferably the organic photovoltaic component or the organic photoactive sensor, comprises
a first substrate, an electrode, a counterelectrode, and an organic layer system, wherein the organic layer system is arranged between the electrode and the counterelectrode.

The organic layer system comprises at least a first photoactive layer, wherein the first photoactive layer comprises a first acceptor material and a first donor material.

The organic layer system comprises at least a first electron transport layer, wherein the first electron transport layer comprises a first electron transport matrix material and at least a concentration of 0.1 vol.%, preferably at least 0.5 vol.%, of a first n-dopant, wherein the first n-dopant is an anti-aromatic compound, and/or
the organic layer system comprises at least a first hole transport layer, wherein the first hole transport layer comprises a first hole transport matrix material and at least a concentration of 0.1 vol.%, preferably at least 0.5 vol.%, of a first p-dopant, wherein the p-dopant is an anti-aromatic compound.

Preferabyl, the light-harvesting component, preferably the organic photovoltaic component or the organic photoactive sensor, comprises
a first substrate, an electrode, a counterelectrode, and an organic layer system, wherein the organic layer system is arranged between the electrode and the counterelectrode.

The organic layer system comprises at least a first photoactive layer, wherein the first photoactive layer comprises a first acceptor material and a first donor material.

The organic layer system comprises at least a first electron transport layer, wherein the first electron transport layer comprises a first electron transport matrix material and at least a concentration of 0.1 vol.%, preferably at least 0.5 vol.%, of a first n-dopant, wherein the first n-dopant is an anti-aromatic compound,
wherein the n-dopant is preferably a compound according to formula (I.1) 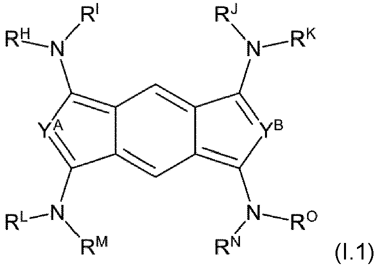 or their radical cations, radical cation salts, dications, dication salts, or their charge transfer complexes with acceptors as electron transport material,
   in which
   Y^{A} is selected from C-H, nitrogen (N), and C-R^{P},
   Y^{B} is selected from C-H, nitrogen (N), and C-R^{Q}, and
   wherein in compounds of formula (X) each of R^{H}, R^{I}, R^{J}, R^{K}, R^{L}, R^{M}, R^{N}, R^{O}, R^{P}, and R^{Q} are independently selected from
      - C1-C6-alkyl, C1-C6-haloalkyl, C3-C10 Cycloalkyl,

      - C6-C14-aryl or heteroaryl,
   wherein heteroaryl has 4 to 13 carbon atoms,
   wherein heteroaryl has 1, 2 or 3 identical or different heteroatoms or heteroatom-containing groups as ring members, selected from N, O, S, SO and SO2,
   wherein C6-C14-aryl and heteroaryl are unsubstituted or substituted by 1, 2, 3, 4 or 5 identical or different radicals R^{R};
   wherein R^{R} represents CN, F, Cl, CF3, OCF3, SCF3, SF5, SO2CF3, C1-C4-alkyl, C1-C4-haloalkyl, C1-C6-alkoxy or C6-C14-aryl, which is unsubstituted or substituted by 1, 2 or 3 identical or
different radicals selected from F, CF3, CN, C1-C4-alkyl and C1-C4-haloalkyl and
the organic layer system comprises at least a first hole transport layer, wherein the first hole transport layer comprises a first hole transport matrix material and at least a concentration of 0.1 vol.%, preferably at least 0.5 vol.%, of a first p-dopant, wherein the p-dopant is an anti-aromatic compound,
wherein the p-dopant is preferably a compound according to formula (II) 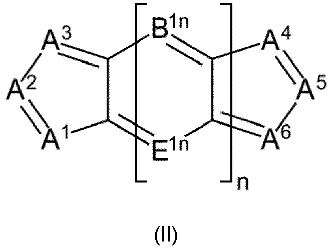 Or their radical anions, radical anion salts, dianions, dianionic salts or their charge transfer complexes with donors as hole transport material,
   in which
   n is 0, 1, 2, 3
   A², A⁵ are nitrogen, carbon-electron withdrawing group or carbon-hydrogen,
   A¹, A³, A⁴, A⁶, are N or carbon-electron withdrawing group or carbon-hydrogen,
   B¹ⁿ, E¹ⁿ are nitrogen, carbon-electron withdrawing group, or carbon-hydrogen.
   A², A⁵ are nitrogen, carbon-electron withdrawing group or carbon-hydrogen,
   A¹, A³, A⁴, A⁶, are N or carbon-electron withdrawing group or carbon-hydrogen,
   B¹ⁿ, E¹ⁿ are nitrogen, carbon-electron withdrawing group, or carbon-hydrogen.

A further object of the invention is an **electricity generating window** comprising a light-harvesting component according to the invention, wherein at least the first substrate is a transparent substrate, preferably the first substrate is a glass substrate and a second substrate is a transparent substrate, more preferably a first substrate and a second substrate is a glass substrate, wherein the electrode, the counterelectrode and the organic layer system are positioned adjacent to the first glass substrate, preferably between the first glass substrate and the second transparent substrate, more preferably between the first and the second glass substrate.

A further object of the invention is the use of the light harvesting component according to the invention, preferably of the organic photovoltaic component according to the invention, for the production of electrical energy at a window.

### Desciption of the invention

Aromaticity is a fundamental concept in chemistry. It is described by Hückel's rule that states that a cyclic planar π-system is aromatic when it shares 4n+2 π-electrons and antiaromatic when it possesses 4n π-electrons. n is understood as an integer with n≥0. Antiaromatic compounds are predicted to exhibit remarkable charge transport properties and high redox activities.

Surprisingly, anti-aromatic compounds were found to be suitable for an application for p-doping or n-doping of matrix molecules.

Due to their antiaromatic nature, the first n-dopants, preferably of formula (I), more preferably of formula (I.1), provide two electron donors, i.e. the compounds tend to donate two electrons in order to reach an aromatic state. Accordingly, the resulting compounds formed in the vicinity of electron acceptors are biscations or dications.

Advantageously, the first n-dopants according to the invention tend to donate more than one electron and therefore show a high doping efficiency.

In addition, the resulting biscations or dications are in an aromatic state and accordingly have a very low absorption, especially in the visible and near-infrared range.

Due to their antiaromatic nature, the first p-dopants, preferably of formula (II), more preferably of formula (II.1), provide two electron acceptors, i.e. the compounds tend to accept two electrons in order to reach an aromatic state. Accordingly, the resulting compounds formed in the vicinity of electron donors are bisanions or dianions. Advantageously, the compounds according to the invention tend to accept more than one electron and therefore show a high doping efficiency.

In addition, the resulting bisanions or dianions are in an aromatic state and accordingly have a very low absorption, especially in the visible and near-infrared range.

The invention has the following advantages:
- Antiaromatic compounds were found to have a wide application range due to their antiaromatic nature. Depending on the nature of the substituents (EDG vs. EWG), the compounds can be used for n- as well as p-side application in organic electronic devices
- A light harvesting component using a charge carrier transport layer, which comprises a first dopant that is an antiaromatic compound, comprises charge carrier transport layers that show advantageously good transport properties.
- Anti-aromatic compounds are advantageously suitable as electron donors for use as n-dopants.
- Anti-aromatic compounds exhibit better conductivities compared to known electron donors.
- Anti-aromatic compounds are advantageously suitable as electron acceptors for use as p-dopants
- Furthermore, anti-aromatic compounds are characterized by a higher doping efficiency, while providing two-electron donors or two-electron acceptors respectively
- The two-fold reduced (bis-anions) or two-fold oxidized derivatives (bis-cations) of the anti-aromatic compounds show only a low absorption of the doped layer. Therefore, parasitic absorption and emissions can be reduced or even prevented.
- As an advantage, the dications or the dicationic salts of the dopant are transparent, i.e. the first n-dopant in the first electron transport layer and/or the first p-dopant in the first hole transport layer are transparent if combined with suitable charge carrier matrix materials.
- The low absorption of the first dopantsin the charge carrier transport layer reduces parasitic absorption in the charge carrier transport layers, i.e. the absorption of the hole transport layer and/or the electron transport layer can be reduced.
- The low absorption of the charge carrier transport layers leads to more transparent light harvesting component, preferably to a more transparent organic photovoltaic component.
- The conductivity of the charge carrier layers is increased compared to the intrinsic charge carrier matrix materials.
- The transmission of light through the light harvesting component, preferably the transmission of light through the organic photovoltaic component, can be enhanced while retaining the sufficient charge carrier transport properties of the charge carrier transport layers.
- Anti-aromatic compounds are suitable for the production of organic photovoltaic components or organic photoactive sensors, both by means of solvent processing and by vacuum reprocessing.
- The sensitivity of the organic sensors can be increased with anti-aromatic compounds due to their better transparency.

The advantage of the invention results from the application of antiaromatic compounds as dopants in the first charge carrier transport layer.

By the application of anti-aromatic systems as p-doping agents or n-doping agents, the charge carrier transport layers show a sufficient electrical conductivity due to the given advantageous electron affinity or electron donating ability of the doping agents.

In addition, the antiaromatic compound show a low diffusion coefficient that ensure the structure of the light harvesting component to stay stable in time.

Accordingly, the light harvesting compounds show an improved long-time stability.

To apply dopants that are an anti-aromatic compound has a lot of advantages.

Accordingly, the first dopant will show a low absorption if the first dopant, is in the twice oxidized form. The first n-dopant will show a low absorption if the first n-dopant is in the twice oxidized form of a bis cation. In addition, the the first p-dopant will show a low absorption if the first dopant is in the twice oxidized form of a bis-anion.

Accordingly, the first dopant, especially the first n-dopant and/or the first p-dopant is transparent, if the dopant is arranged to a corresponding matrix molecule, especially the first n-dopant is transparent if arranged in the first electron transport layer close to an electron acceptor molecule. The first p-dopant is transparent if arranged in the first hole transport layer close to an electron donor molecule.

Accordingly, the first dopant, especially the first n-dopant and/or the first p-dopant, contributes only to small amount to the absorption of the first charge carrier transport layer, especially the first electron transport layer and/or the first hole transport layer.

To build such a first charge carrier transport layer, the first dopant is coevaporated with a first charge carrier matrix material, preferably a first electron matrix material or a first hole transport material.

### Definitions

The expression "anti-aromatic compound" comprises in the context of the invention any carbon containing compound that posseses a planar π-system and possesses 4n π-electrons. N is understood as an integer with n≥1. Any anti-aromatic compound can be substituted or unsubstituted,and includes their radical cations, radical cation salts, dications, dication salts, or their charge transfer complexes with donors.

For clarity, the term "indacenes", as used in the sense of the invention, comprises indazenes as well as aza indazenes wherein one, two, three or four carbon atoms are replaced by nitrogen.

The expression "electron withdrawing group" (EWG) comprises in the context of the invention an atom or group that draws electron density from neighboring atoms or groups towards itself, usually by resonance or inductive effects. Examples for electron withdrawing groups are trifluoromethyl, pentafluoroethyl, halogen and cyano. All groups that are more electron withdrawing than Hydrogen are considered electron withdrawing.

The expression "electron donating group" (EDG) comprises in the context of the invention an atom or group that draws electron density from neighboring atoms or groups towards itself, usually by resonance or inductive effects. Examples for electron donating groups are methoxy, dimethylamino, C1-C4-alkyl, C1-C6-alkoxy. Are groups that are more electron donating than Hydrogen are considered electron donating.

The expression "aryl" comprises in the context of the invention mono- or polynuclear aromatic hydrocarbon radicals with usually 6 to 14, especially preferably 6 to 10 carbon atoms. Examples of aryl are especially phenyl, naphthyl, indenyl, fluorenyl, anthracenyl, phenanthrenyl, naphthacenyl, chrysenyl, pyrenyl, etc. and especially phenyl or naph-thyl.

The terms radical anions, radical anionic salts, dianions, dianionic salts describe ionic compounds that result from the electron transfer, i.e. reduction, of a non-charged parent compound with one electron in case of radical anions and radical anion salts and two electrons in the case of dianions and dianionic salts.

The term charge transfer complexes describe a supramolecular assembly of an electron donor, for example an hole transport material and an electron acceptor, for example a p-dopant.

In the context of the invention, alkyl refers to unbranched or branched saturated hydrocarbon groups. The prefix Cn-Cm indicates the number of carbon atoms that a molecule or residue designated thereby may contain. In the context of the invention, the expression C1-C4-alkyl refers to unbranched or branched saturated hydrocarbon groups having 1 to 4 carbon atoms. C1-C4-alkyl are e.g. methyl, ethyl, propyl, 1-methylethyl, butyl, 1-methylpropyl or2-methylpropyl, 1,1-dimethylethyl.

In the context of the invention, the expression C1-C6-alkyl refers to unbranched or branched saturated hydrocarbon groups having 1 to 6 carbon atoms. C1-C6-alkyl are e.g. methyl, ethyl, propyl, 1-methylethyl, butyl, 1-methylpropyl, 2-methylpropyl, 1,1-dimethylethyl, pentyl, 1-methylbutyl, 2-methylbutyl, 3-methylbutyl, 2,2-dimethylpropyl, 1-ethylpropyl, hexyl, 1,1-dimethylpropyl, 1,2-dimethylpropyl, 1-methylpentyl, 2-methylpentyl,3-methylpentyl, 4-methylpentyl, 1,1-dimethylbutyl, 1,2-dimethylbutyl, 1,3-dimethylbutyl, 2,2-dimethylbutyl, 2,3-dimethylbutyl, 3,3-dimethylbutyl, 1-ethylbutyl, 2-ethylbutyl, 1,1,2-trimethylpropyl, 1,2,2-trimethylpropyl, 1-ethyl-1-methylpropyl or 1-ethyl-2-methylpropyl. C1-C4-alkyl refers, e.g. to methyl, ethyl, propyl, 1-methylethyl, butyl, 1-methylpropyl, 2-methylpropyl or 1,1-dimethylethyl.

In the context of the invention, cycloalkyl refers to unbranched or branched saturated cyclic hydrocarbon groups. The prefix Cn-Cm indicates the number of carbon atoms that a molecule or residue designated thereby may contain. In the context of the invention, the expression C3-C10-cycloalkyl refers to unbranched or branched saturated cyclic hydrocarbon groups having 3 to 10 carbon atoms. C3-C10-cycloalkyl are e.g. cyclopropyl, cyclobutyl, cyclopentyl, methylcyclopentyl, cyclohexyl, cycloheptyl, cyclooctyl, cyclononyl or cyclodecyl.

In the context of the invention the expression C1-C6-alkoxy refers to an unbranched or branched saturated C1-C6-alkyl group as defined above, which is bound via an oxygen atom. Alkoxy radicals with 1 to 4 carbon atoms are preferred, particularly preferred are 1 or 2 carbon atoms. C1-C2-alkoxy is methoxy or ethoxy. C1-C4-alkoxy is e.g. methoxy, ethoxy, n-propoxy, 1-methylethoxy (isopropoxy), butoxy, 1-methylpropoxy (sec-butoxy), 2-methylpropoxy (isobutoxy) or 1,1-dimethylethoxy (tert-butoxy). C1-C6-alkoxy comprises the meanings given for C1-C4-alkoxy and additionally e.g. pentoxy, 1 methylbutoxy, 2-methylbutoxy, 3-methylbutoxy, 1,1-dimethylpropoxy, 1,2-dimethylpropoxy, 2,2-dimethylpropoxy, 1-ethylpropoxy, hexyloxy, 1-methylpentoxy, 2-methylpentoxy, 3-methylpentoxy, 4-methylpentoxy, 1,1-dimethylbutoxy, 1,2-dimethylbutoxy, 1,3-dimethylbutoxy, 2,2-dimethylbutoxy, 2,3-dimethylbutoxy and 3,3-dimethylbutoxy.

The expression "haloalkyl" refers to partially or fully halogenated alkyl chains. In other words, one or more hydrogen atoms, for example 1, 2, 3, 4 or 5 hydrogen atoms bonded to one or more carbon atoms of alkyl, are replaced by a halogen atom, in particular by fluorine or chlorine.

The expression "CN" denotes the cyano group (-C=N).

The expression "halogen" denotes in each case fluorine, bromine, chlorine or iodine, particularly fluorine, chlorine and bromine.

The expression "heteroaryl" comprises in the context of the invention mononuclear aromatic hydrocarbon radicals with 4 to 5 carbon atoms, wherein 1, 2 or 3 carbon atoms have been replaced by 1, 2 or 3 nitrogen atoms as ring members. The hetaryl group may be attached 25 to the remainder of the molecule via a ring carbon or via a ring nitrogen. Examples of 5- or 6-membered aromatic heterocyclic rings (also called heteroaromatic rings or hetaryl) are 2-pyrrolyl, 3-pyrrolyl, 3-pyrazolyl, 4-pyrazolyl, 5-pyrazolyl, 2-imidazolyl, 4-imidazolyl, 1,3,4-triazol-2-yl, 2-pyridinyl, 3-pyridinyl, 4-pyridinyl, 3-pyridazinyl, 4-pyridazinyl, 2-pyrimidinyl, 4-pyrimidinyl, 5-pyrimidinyl and 2-pyrazinyl.

In a preferred embodiment, the first charge carrier transport layer is a first electron transport layer and the first charge carrier transport matrix material is a first electron transport matrix material and the first dopant is a first n-dopant.

In another preferred embodiment, the first charge carrier transport layer is a first hole transport layer and the first charge carrier transport matrix material is a first hole transport matrix material and the first dopant is a first p-dopant.

According to the invention, the term "electron transport layer" (ETL) includes a layer comprising an electron transport matrix material and an n-dopant. This term also applies to an n-type part of a **pn-junction** as well as to an **electron extraction layer.** The main role of the ETL is to improve the collection and extraction efficiency of electrons out of the component.

According to the invention, the term "hole transport layer" (HTL) includes a layer comprising a hole transport matrix material and a p-dopant. This term also applies to a p-type part of a **pn-junction** as well as to a **hole extraction layer** and a anode buffer layer. The hole extraction layer may be placed directly adjacent to the anode.

The main role of this HTL is to improve collection and extraction efficiency of holes.

In a preferred embodiment, the first charge carrier transport layer according to the invention is a **first electron transport layer,** wherein the first electron transport layer comprises at least a concentration of 0.5 vol.%, preferably at least 1 vol.%, of the first n-dopant. Preferably, the doping concentration is in the range of **0.5 vol.% - 30 vol.%, more** preferably in the range of 1 vol.% and 20 vol.%.

In a preferred embodiment, the first charge carrier transport layer according to the invention is a **first hole transport layer,** wherein the hole transport layer comprises at least a concentration of 0.5 vol.%, preferably at least 1 vol.%, of the first p-dopant. Preferably, the doping concentration is in the range of **0.5 vol.% - 30 vol.%, more** preferably in the range of 1 vol.% and 20 vol.%.

Preferably, the light harvesting component is an organic photoactive sensor. As an advantage, the reduced absorption of the first charge carrier transport layer and/or the first charge carrier transport layers, preferably of the hole transport layer and/or the electron transport layer, can reduce the parasitic absorption in these layers and therefore improve the sensitivity of the organic photoactive sensor.

### N-dopant

Preferred is a light harvesting component according to the invention, wherein the first charge carrier transport layer is a first electron transport layer and the charge carrier transport matrix material is a first electron transport matrix material and the first dopant is a first n-dopant.

Preferably, the first n-dopant, which is an antiaromatic compound, is a compound according to formula (I) 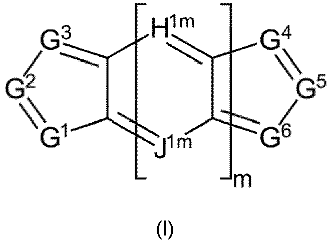 or radical cations, radical cation salts, dications, dicationic salts or their charge transfer complexes with acceptors as electron transport material, in which
m is 0, 1, 2, 3
G²,G⁵ are nitrogen, carbon-electron donating group, carbon-electron withdrawing group, or carbon-hydrogen,
G¹, G³, G⁴, G⁶, H¹ⁿ, J¹ⁿ are carbon-electron donating group, carbon-electron withdrawing group, or carbon-hydrogen.

Preferably, the n-dopant is a compound according to formula (I.1) 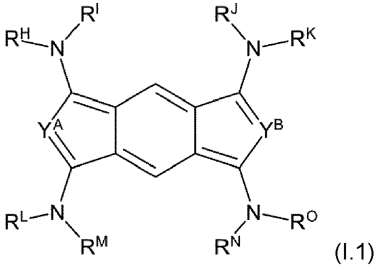 or their radical cations, radical cation salts, dications, dication salts, or their charge transfer complexes with acceptors as electron transport material,
in which
Y^{A} is selected from C-H, nitrogen (N), and C-R^{P},
Y^{B} is selected from C-H, nitrogen (N), and C-R^{Q}, and
wherein in compounds of formula (X) each of R^{H}, R^{I}, R^{J}, R^{K}, R^{L}, R^{M}, R^{N}, R^{O}, R^{P}, and R^{Q} are independently selected from
   - C1-C6-alkyl, C1-C6-haloalkyl, C3-C10 Cycloalkyl,

   - C6-C14-aryl or heteroaryl,
wherein heteroaryl has 4 to 13 carbon atoms,
wherein heteroaryl has 1, 2 or 3 identical or different heteroatoms or heteroatom-containing groups as ring members, selected from N, O, S, SO and SO2,
wherein C6-C14-aryl and heteroaryl are unsubstituted or substituted by 1, 2, 3, 4 or 5 identical or different radicals R^{R};
wherein R^{R} represents CN, F, Cl, CF₃, OCF₃, SCF₃, SF₅, SO₂CF₃, C1-C4-alkyl, C1-C4-haloalkyl, C1-C6-alkoxy or C6-C14-aryl, which is unsubstituted or substituted by 1, 2 or 3 identical or
different radicals selected from F, CF₃, CN, C1-C4-alkyl and C1-C4-haloalkyl.

### Electron transport matrix material

Preferably, the **electron matrix material** is selected from a matrix material showing an acceptor level (LUMO) between -3,3 eV to -5.0 eV, preferably -3.5 to -4.5 eV. In particular, such dopable electron matrix materials can be substituted such as PCMB or unsubstituted fullerenes such as C60, C70 and its derivatives or non-fullerene acceptors with suitable acceptor level, for example compounds reported in Nature Reviews Materials 3, Article number: 18003 (2018).

It is understood that even other suitable organic matrix materials/matrix compounds, in particular electron-conducting materials can be used that have semi-conductive properties.

### P-Dopant

Preferred is a light harvesting component according to the invention, wherein the first charge carrier transport layer is a first hole transport layer and the charge carrier transport matrix material is a first hole transport matrix material and the first dopant is a first p-dopant.

Preferably, the first p-dopant is a compound according to formula (II) 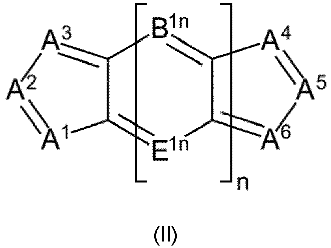 Or their radical anions, radical anion salts, dianions, dianionic salts or their charge transfer complexes with donors as hole transport material,
in which
n is 0, 1, 2, 3
A², A⁵ are nitrogen, carbon-electron withdrawing group or carbon-hydrogen,
A¹, A³, A⁴, A⁶, are N or carbon-electron withdrawing group or carbon-hydrogen,
B¹ⁿ, E¹ⁿ are nitrogen, carbon-electron withdrawing group, or carbon-hydrogen.
A², A⁵ are nitrogen, carbon-electron withdrawing group or carbon-hydrogen,
A¹, A³, A⁴, A⁶, are N or carbon-electron withdrawing group or carbon-hydrogen,
B¹ⁿ, E¹ⁿ are nitrogen, carbon-electron withdrawing group, or carbon-hydrogen.

Preferably, the first p-dopant is a compound according to formula (!!.1): 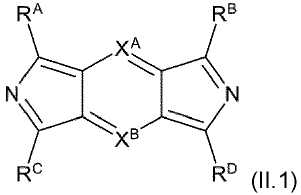 or their radical anions, radical anionic salts, dianions, dianionic salts, or their charge transfer complexes with donors,
in which
X^{A} is selected from C-H, nitrogen , C-CF₃, C-Cl, C-Br, and C-R^{E},
X^{B} is selected from C-H, nitrogen, C-CF₃, C-Cl, C-Br, and C-R^{F}, and
wherein in compounds of formula (II.1) R^{A}, R^{B}, R^{C}, R^{D}, R^{E}, and R^{F} are independently selected from C₆-C₁₄-aryl or heteroaryl,
wherein heteroaryl has 4 to 13 carbon atoms,
wherein heteroaryl has 1, 2 or 3 identical or different heteroatoms or heteroatom-containing groups as ring members, selected from N, O, S, SO and SO₂,
wherein C₆-C₁₄-aryl and heteroaryl are unsubstituted or substituted by 1, 2, 3, 4 or 5 identical or different radicals R^{G};
wherein R^{G} is selected from CN, F, Cl, CF₃, OCF₃, SCF₃, SF₅, SO₂CF₃, C₁-C₄-alkyl, C₁-C₄-haloalkyl, C₁-C₄-haloalkylaryl or C₆-C₁₄-aryl, which is unsubstituted or substituted by 1, 2 or 3 identical or different radicals selected from F, CN, C₁-C₄-alkyl and C₁-C₄-haloalkyl.

In a preferred embodiment, the light harvesting component comprises both a first electron transport layer comprising a first first n-dopant which is an antiaromatic compound, preferably an n-dopant as described herein, and a first hole transport layer, comprising a a first p-dopant which is an antiaromatic compound, preferably a p-dopant as described above.

Preferably, the light harvesting component comprises a second charge carrier transport layer which is a second hole transport layer, wherein the second hole transport layer comprises a second hole transport matrix material and at least a concentration of 0.1 vol.%, preferably at least 0.5 vol.%, of a second p-dopant. The second p-dopant is preferably a Cerium complex and is a compound of the formula (III):

Ce⁴⁺( L₁L₂L₃L₄⁻)₄ (III)

or mixtures thereof, wherein
L₁; L₂; L₃; and L₄ are independently from each other selected from a bidentate ligand comprising at least two cabon atoms, preferably at least eight carbon atoms.

In one embodiment, the ligands L₁; L₂; L₃; and L₄ are similar.

In another embodiment the ligands L₁; L₂; L₃; and L₄ are different.

In a preferred embodiment, the light harvesting component comprises a second hole transport layer and either a first electron transport layer or a first hole transport layer or a first electron transport layer and a first hole transport layer.

Accordingly, this second hole transport layer can be the only hole transport layer in the light harvesting component. In this case, there is a first electron transport layer comprising a first dopant, wherein the first dopant is a first n-dopant and a second hole transport layer comprising a second dopant, wherein the second dopant is a p-dopant.

Advantageously, this type of Cerium complexes were shown to have good doping properties as well as a low aborption when used as p-dopant in a hole transport layer. Accordingly, the properties of the light harvesting component can be further enhanced. For an organic photovoltaic component, the transmission can be further increased while retaining good hole transport properties. For an organic photoactive sensor, the sensitivity can be increased due to the reduced parasitic absorption in the hole transport layer.

Preferably, the second p-dopant is is a compound wherein the p-dopant is a compound according to formula (III.1)

Ce⁴⁺(L₁L₂L₃L₄)⁴⁻ (III.1)

or mixtures thereof,
wherein L₁; L₂; L₃ ; and L₄ are independently from each other selected from a bidentate ligand having the general formula (IV) 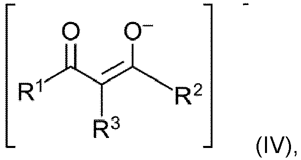 wherein
- R¹, R², R³: independently from each other represent CN, C₁-C₆-alkyl, C₁-C₆-haloalkyl, C₆-C₁₄-aryl or hetaryl having 4 to 13 carbon atoms, wherein hetaryl has 1, 2 or 3 identical or different heteroatoms or heteroatom-containing groups as ring members, selected from N, O, S, SO and SO₂, wherein aryl and hetaryl are unsubstituted or substituted by 1, 2, 3, 4 or 5 identical or different radicals R⁴;
- R⁴: represents CN, halogen, C₁-C₄-alkyl, C₁-C₄-haloalkyl or C₆-C₁₄-aryl, which is unsubstituted or substituted by 1, 2 or 3 identical or different radicals selected from C₁-C₄-alkyl,C₁-C₄-haloalkyl, OCF₃, SCF₃, SF₅, SO₂CF₃.

In one embodiment, the ligands L₁; L₂; L₃; and L₄ are similar.

In another embodiment the ligands L₁; L₂; L₃; and L₄ are different.

As an advantage, excellent overall transparency of light harvesting components, preferably of organic photovoltaic components or organic sensors can be reached if combined with other transparent doping technologies. In particular Ce(IV) compounds are advantageously suitable as electron acceptors for use as p-dopants and show a low absorption.

### Hole transport matrix materials

Preferably, the **hole matrix material** is selected from a matrix material showing a donor level (HOMO) between -4.0 to -6.5 eV, preferably between -4.6 to -6.0 eV. In particular, such dopable hole matrix materials can be arylated benzidines, triaryl amines, oligothiphenes, carbazole derivatives. It is understood that even other suitable organic matrix materials/matrix compounds, in particular hole-conducting materials can be used that have semi-conductive properties.

In particular matrix /matrix comprises at least one matrix compound and at least one compound of the formula (I), wherein the matrix compound is selected from4,4',4"-tris(N-(2-naphthyl)-N-phenyl-amino)triphenylamine (2-TNATA), 4,4',4"-tris(N-3-methylphenyl-N-phenyl-amino)triphenylamine (m-MTDATA), N,N,N',N'-tetrakis(4-methoxyphenyl)benzidine (MeO-TPD), (2,2',7,7'-tetrakis-(N,N-diphenylamino)-9,9'-spirobifluorene (spiro-TTB), N,N'-bis(naphthalen-1-yl)-N,N'-bis(phenyl)-benzidine, N,N'-bis(naphthalen-1-yl)-N,N'-bis(phenyl)-9,9-spiro-bifluorene, 9,9-bis[4-(N,N-bis-biphenyl-4-yl-amino)phenyl]-9H-fluorene, 2,2'-bis[N,N-bis(biphenyl-4-yl)amino]-9,9-spiro-bifluorene, N,N'-((9H-fluoren-9,9-diyl)bis(4,1-phenylen))bis(N-([1,1'-biphenyl]-4-yl)-[1,1'-biphenyl]-4-amine) (BPAPF), N,N'-bis(phenanthren-9-yl)-N,N'-bis(phenyl)-benzidine, 1,3,5-tris{4-[bis(9,9-dimethyl-fluoren-2-yl)amino]phenyl}benzene, tri(terphenyl-4-yl)amine, N-(4-(6-((9,9-dimethyl-9H-fluoren-2-yl)(6-methoxy-[1,1'-biphenyl]-3-yl)amino)-1,3,3-trimethyl-2,3-dihydro-1H-inden-1-yl)phenyl)-N-(6-methoxy-[1,1'-biphenyl]-3-yl)-9,9-dimethyl-9H-fluoren-2-amine, N-([1,1'-biphenyl]-4-yl)-N-(4-(6-([1,1'-biphenyl]-4-yl(9,9-dimethyl-9H-fluoren-2-yl)amino)-1,3,3-trimethyl-2,3-dihydro-1H-inden-1-yl)phenyl)-9,9-dimethyl-9H-fluoren-2-amine, N,N-di([1,1'-biphenyl]-4-yl)-3-(4-(di([1,1'-biphenyl]-4-yl)amino)phenyl)-1,1,3-trimethyl-2,3-dihydro-1H-inden-5-amine, N-(4-(6-(bis(9,9-dimethyl-9H-fluoren-2-yl)amino)-1,3,3-trimethyl-2,3-dihydro-1H-inden-1-yl)phenyl)-N-(9,9-dimethyl-9H-fluoren-2-yl)-9,9-dimethyl-9H-fluoren-2-amine, N-(4-(6-(9,9'-spirobi[fluoren]-2-yl(9,9-dimethyl-9H-fluoren-2-yl)amino)-1,3,3-trimethyl-2,3-dihydro-1H-inden-1-yl)phenyl)-N-(9,9-dimethyl-9H-fluoren-2-yl)-9,9'-spirobi[fluoren]-2-amine, N-(4-(6-(dibenzo[b,d]furan-2-yl(9,9-dimethyl-9H-fluoren-2-yl)amino)-1,3,3-trimethyl-2,3-dihydro-1H-inden-1-yl)phenyl)-N-(9,9-dimethyl-9H-fluoren-2-yl)dibenzo[b,d]furan-2-amine, 9-(4-(6-(9H-carbazol-9-yl)-1,3,3-trimethyl-2,3-dihydro-1H-inden-1-yl)phenyl)-9H-carbazole, N-([1,1'-biphenyl]-4-yl)-3-(4-([1,1'-biphenyl]-4-yl(4-methoxyphenyl)amino)phenyl)-N-(4-methoxyphenyl)-1,1,3-trimethyl-2,3-dihydro-1H-inden-5-amine, 3-(4-(bis(6-methoxy-[1,1'-biphenyl]-3-yl)amino)phenyl)-N,N-bis(6-methoxy-[1,1'-biphenyl]-3-yl)-1,1,3-trimethyl-2,3-dihydro-1H-inden-5-amine, N1-([1,1'-biphenyl]-4-yl)-N1-(4-(6-([1,1'-biphenyl]-4-yl(4-(diphenylamino)phenyl)amino)-1,3,3-trimethyl-2,3-dihydro-1H-inden-1-yl)phenyl)-N4,N4-diphenylbenzene-1,4-diamine, N,N-di([1,1'-biphenyl]-4-yl)-4'-(6-(4-(di([1,1'-biphenyl]-4-yl)amino)phenyl)-1,3,3-trimethyl-2,3-dihydro-1H-inden-1-yl)-[1,1'-biphenyl]-4-amine, N-(4-(5-(bis(9,9-dimethyl-9H-fluoren-2-yl)amino)-1,3,3-trimethyl-2,3-dihydro-1H-inden-1-yl)phenyl)-N-(9,9-dimethyl-9H-fluoren-2-yl)-9,9-dimethyl-9H-fluoren-2-amine, N-(4-(6-(bis(9,9-dimethyl-9H-fluoren-2-yl)amino)-1,3,3-trimethyl-2,3-dihydro-1H-inden-1-yl)phenyl)-N-(9,9-dimethyl-9H-fluoren-2-yl)-9,9-dimethyl-9H-fluoren-2-amine, N,N'-bis(9,9-dimethyl-fluoren-2-yl)-N,N'-diphenyl-benzidine (BF-DPB), N,N'-((9H-fluorene-9,9-diyl)bis(4,1-phenylene))bis(N-([1,1'-biphenyl]-4-yl)-[1,1'-biphenyl]-4-amine) (BPAPF), N4,N4,N4',N4'-tetrakis(9,9-dimethyl-9H-fluoren-2-yl)-[1,1'-biphenyl]-4,4'-diamine (TDMFB), N-([1,1'-biphenyl]-2-yl)-N-(9,9-dimethyl-9H-fluoren-2-yl)-9,9'-spirobi[fluoren]-2-amine, (2,7-bis[N,N-bis(4-methoxyphenyl)amino]-9,9-spirobi[9*H*-fluorene] (spiro-MeO-TPD), a mixture of N-(4-(5-(bis(9,9-dimethyl-9H-fluoren-2-yl)amino)-1,3,3-trimethyl-2,3-dihydro-1H-inden-1-yl)phenyl)-N-(9,9-dimethyl-9H-fluoren-2-yl)-9,9-dimethyl-9H-fluoren-2-amine and N-(4-(6-(bis(9,9-dimethyl-9H-fluoren-2-yl)amino)-1,3,3-trimethyl-2,3-dihydro-1H-inden-1-yl)phenyl)-N-(9,9-dimethyl-9H-fluoren-2-yl)-9,9-dimethyl-9H-fluoren-2-amine, N-([1,1'-biphenyl]-4-yl)-9,9-dimethyl-N-(4-(9-phenyl-9H-carbazol-3-yl)phenyl)-9H-fluoren-2-amine and mixtures thereof.

### Tandem device

In a preferred embodiment, the light harvesting component, preferably the organic photovoltaic component, further comprises a second photoactive layer and at least a first charge recombination layer, wherein the first charge recombination layer is arranged between the first photoactive layer and the second photoactive layer. The second photovoltaic layer comprises a second acceptor material and a second donor material. This type is also called a tandem light harvesting component or a tandem organic photovoltaic component.

In the light harvesting component according to the invention, the first charge recombination layer preferably comprises the first charge transport layer comprising the first dopant. Preferably, the first charge recombination layer comprises a first n-dopant according to the invention and/or a first p-dopant according to the invention.

In a preferred embodiment a light harvesting component according to the invention, comprises at least one pn-junction, which comprises at least one or more anti-aromatic compounds. The pn-junction may be a charge recombination contact, for example connecting two light-absorbing units or two photoactive layers. The pn-junction may also be used to connect an anode or a cathode to a photoactive layer, i.e. to a light absorbing layer.

Preferably, the light harvesting component is a triple light harvesting component additionally comprising a third photoactive layer or even a quadruple light harvesting component comprising a fourth photoactive layer. The application of the first p-dopant and/or the first n-dopant in at least one of the charge recombination layers that are arranged between the photoactive layers may improve the performance of these components.

### Substrate

A transparent substrate can be an inorganic material such as glass or an organic material such as polyethylene terephthalate (PET), polyethylene naphthalate (PEN), polycarbonate, and PMMA . Depending on the intended use, a rigid or flexible substrate can be used.

Advantageously, the transparent substrate can be realized as a rigid substrate. The thickness of the substrate is preferably between 1 mm and 20 mm, more preferably between 5 mm and 15 mm.

Advantageously, the transparent substrate can be realized as a flexible substrate.

### Photoactive Layer

The photoactive layer of the light harvesting component may comprise two layers, each having a homogeneous composition and forming a planar donor-acceptor heterojunction. The photoactive layer may also comprise a mixed layer and form a donor-acceptor heterojunction in the form of a donor-acceptor bulk heterojunction.

A photoactive layer preferably contains at least an acceptor material and at least adonor material, wherein the acceptor material or the donor material preferably show an absorption of at least 0,01, preferably of 0,1, for a layer thickness of 100 nm. This absorption applies at least for a range of 30 nm, wherein the range of 30 nm is in a range from 380 nm to 2500 nm.

In addition, the light harvesting component may also comprise other layers, e.g., selected from exciton blocking layer, hole blocking layer, electron blocking layers, optical spacers, and multiplier layers. Preferably, these layers do not absorb UV-visible light.

Preferably, the light harvesting component according to the invention is in the form of an organic or hybrid solar cell, which are exciton solar cells, dye sensitized solar cells (DSSCs) or perovskite solar cells. Preferred devices for electrophotography are photoconductive materials in organic photoconductors (OPCs).

### Charge carrier transport layer

Preferably, the first charge carrier transport layer has a dopant concentration of at least 0.1%, more preferably 0.5 vol.%, over its entire thickness. The dopant concentration is preferably smaller than 35 %.

In a preferred embodiment the first n-dopant layer has at least an n-dopant concentration of 0.1%, preferably at least 0.5 vol.%, even more preferably not more than 35 %, over its entire thickness and/or the first p-dopant layer has at least a p-dopant concentration of 0.1%, preferably at least 0.5 vol.%, even more preferably not more than 35 %, over its entire thickness.

The first charge carrier transport layer preferably has a conductivity of at least 1·10⁻⁵ S/cm, preferably at least 1·10⁻⁴ S/cm, more preferably at least 1·10⁻³ S/cm, even more preferably at least 10⁻³ S/cm or at least 10⁻² S/cm, preferably in the range of 10⁻³ and 10⁻² S/cm.

The light-harvesting component according to the invention preferably comprises a first charge carrier transport layer, wherein the thickness of the charge carrier transport layer is at least 5 nm, preferably at least 15 nm, more preferably at least 25 nm.

The light harvesting component comprises preferably a first charge carrier transport layer of a thickness of at least 10 nm, wherein the charge carrier transport layer is transparent or has an absorption is below 0,1, preferably below 0,02, more preferably below 0,01.

The first charge carrier transport layer is transparent if a layer of a thickness of at least 40 nm, wherein the layer comprises the first charge carrier matrix material as well as the first dopant, has a transmission of at least 60 %. Preferably 80 %, for each wavelength in the range between 450 nm and 800 nm, preferably between 400 nm and 1500 nm.

### Organic photoactive sensor

In one embodiment, the light harvesting component is an organic photoactive sensor. Due to the reduced absorption of the first charge carrier transport layer, the unwanted parasitic absorption of transport layers on the p-side and/or the n-side can be reduced. Therefore, the sensitivity can be increased.

### Electricity generating window

Such an electricity generating window preferably comprises an organic photovoltaic device according to the invention, which is preferably transparent. The photovoltaic device is preferably disposed between the first glazing and the second glazing and includes a transparent substrate, a transparent bottom electrode coupled to the transparent substrate, an active layer coupled to the transparent bottom electrode, and a transparent multilayer top electrode .

The first photoactive layer or one of the photoactive layers is preferably suitable to convert light of the non-visible spectrum into electrical energy, e.g. in the infrared region or in the UV region.

As an advantage, such a electricity generating window can convert light into electrical energy, and thus can generate electrical energy and, at the same time, further reduce building heating by absorbing the IR light while allowing visible light to pass through.

Preferably, the electricity generating window comprises insulated glazing units ( IGUS ) that may include two or more window panes separated by a gap for reducing heat transfer.

An electricity generating window may include a first glass pane, a second glass pane , and an organic photovoltaic component formed on an inner surface of the first glass pane or an inner surface of the second glass pane. In this case one of the glass panes may serve as the first substrate.

In addition, the organic photovoltaic component may comprise a first electrode that is transparent. Preferably the second electrode is transparent.

In some embodiments , the organic photovoltaic component may be configured to provide the convertion of light to electricity and at the same time to reflect infrared light.

Preferably, the organic electronic device is laminated between the first glass pane and the second glass pane.

Preferably, the electricity generating window may also comprise a functional device electrically coupled to the organic photovoltaic component. Preferably, the functiona device may comprise an electrochromic device .

### Doping process

The doping can take place in such a manner that the doping agent is evaporated out of a precursor compound that releases the doping agent under heating and/or irradiation. The irradiation can take place by electromagnetic radiation, especially visible light, UV light or IR light, e.g., by laser light or also by other radiation types. The heat necessary for evaporation can substantially be made available by the irradiation and can also be radiated in a purposeful manner into certain bands of the compounds or precursors or compound complexes such as charge transfer complexes to be evaporated in order to facilitate the evaporation of the compounds by dissociation of the complexes by conversion into excited states. It is understood that the evaporation conditions described in the following are directed to those without irradiation and that uniform evaporation conditions are to be used for purposes of comparison.

It is understood that the compounds used in accordance with the invention are preferably such that they evaporate more or less or practically non-decomposed. However, if necessary, even purposeful precursors can be used as doping source that release the compounds used in accordance with the invention, e.g., acid addition salts, e.g., of a volatile or non-volatile inorganic or organic acid, or their charge transfer complexes, which acids and/or electron donors are preferably not volatile or only slightly volatile or the charge transfer complex itself acts as doping agent.

The doping agent used according to the invention is preferably selected in such a manner that the semiconductive organic material doped with it still has ≥20%, preferably ≥30%, especially preferably ≥50% or 60% of the conductivity (s/cm) of the value at 100°C after a temperature change of 100°C to RT (20°C).

Preferred is a method to produce a doped layer according to the invention produced by the method according to the invention, wherein the doped matrix material is heated at a temperature of at least 50-120°C, preferably 80°-105°C, for a time of 1 - 500 minutes, preferably 5 to 200 minutes, more preferably 10 - 150 minutes, even more preferably 20 - 50 minutes.

The doping can take place in particular in such a manner that the molar ratio of matrix molecule to doping agent, or in the case of oligomeric matrix materials the ratio of matrix monomer number to doping agent is 1:100000, preferably 1:10000, especially preferably 1:5 to 1:1000, e.g., 1:10 to 1:100, e.g., ca. 1:50 to 1:100 or also 1:25 to 1:50.

### Experimental

### N-Dopant

### Synthesis of Example C7

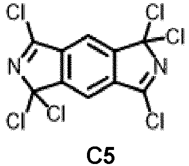

Compound **C5** was prepared according to a reported procedure: Angew. Chem, 1987, 99, 1068-1070.

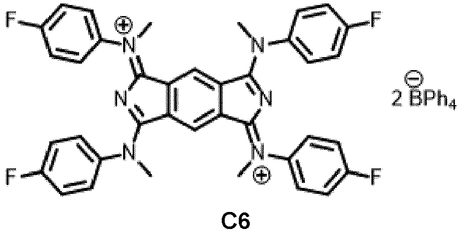

Compound **C5** (2.46 g, 6.78 mmol) was dissolved in THF (50 mL) under a nitrogen atmosphere. 4-Fluoro-N-methylaniline (4.3 g, 34.4 mmol) was added and the mixture was stirred at room temperature for 2 h. The solvent was removed and the remaining solid was washed with a 1:1 solution of dichloromethane and petroleum ether (30 mL) and then with petroleum ether (30 mL). The solid was then dissolved in methanol (50 mL) and a solution of sodium tetraphenylborate (5.9 g, 17.24 g) in methanol (25 mL) was added. The mixture was stirred at room temperature overnight and the solid was filtered off and washed with methanol, ethyl acetate and petroleum ether. The solid was then dried (65 °C, 450 mbar) overnight to obtain compound **C6** (5.22 g, 4.06 mmol, 60 %) as a dark red to brown solid. **APCI-MS:** m/z = 647.2 [M-2BPh₄+H]⁺, 617.3 [M-2Me-2BPh₄+H]⁺.

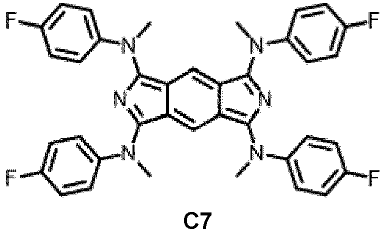

To a mixture of compound C6 (2.00 g, 1.56 mmol) in THF (50 mL) was added KCs (432.0 mg, 3.20 mmol) in portions under a nitrogen atmosphere. The mixture was stirred for 2 h and the solids were filtered off and washed with THF (10 mL). The solvent was removed by distillation under an argon atmosphere to obtain crude compound **C7** (666.0 mg, 1.03 mmol) as a greenish black solid. A part of the material (330.0 mg, 0.51 mmol) was subjected to high vacuum sublimation (1.7 × 10⁻⁶ mbar, up to 260 °C) to obtain compound **C7** (20.0 mg, 30.9 µmmol, 6 %) as a dark green solid. **APCI-MS:** m/z = 647.1 [M+H]⁺.

### P-dopant

### Sample preparation and conductivity measurement Synthesis of Example C4

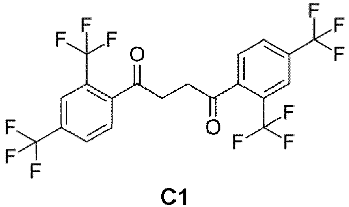

The compound **C1** was prepared according to the procedure for synthesizing 1,4-diketones in: Chem. Sci., 2020,11, 6370-6382

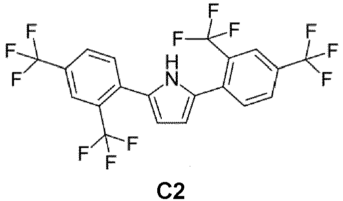

Compound **C1** (19.7 g, 38.6 mmol) and ammonium acetate (5.95 g, 77.2 mmol) were dissolved in EtOH (160 mL) and heated to reflux for 1.5 h.

The solvent was removed under reduced pressure and brine (100 mL) and CH₂Cl₂ (200 mL) were added. The organic layer was isolated and the aqueous layer was washed with CH₂Cl₂ (2x100 mL).

The solvent was removed under reduced pressure and the crude product recrystallized from toluene to give 15.5 g (78%) of the title compound **C2.**

**APCI-MS:** m/z = 491.9 [M+H]⁺

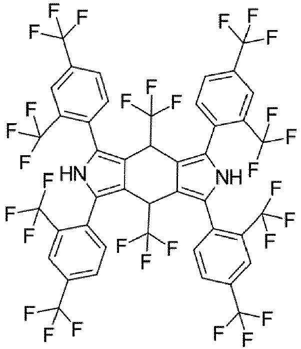

### C3

To a mixture of diarylpyrrole **C2** (8.95 g, 18.22 mmol) in borontrifluoride etherate (70 mL) was added trifluoroacetaldehyde methyl hemiacetal (90%, 6.0 mL, 7.9 mmol, 54.7 mmol) under an argon atmosphere. The mixture was stirred at 60 °C over 1 day and was then poured into ice. The mixture was neutralized with sodium bicarbonate and then extracted twice with ethyl acetate. The solvent was removed and the residue was washed with petroleum ether. The crude product was recrystallized from chlorobenzene to obtain compound **C3** (3.50 g, 3.06 mmol, 34 %) as colorless solid.

**APCI-MS:** m/z = 1142.9 [M+H]⁺

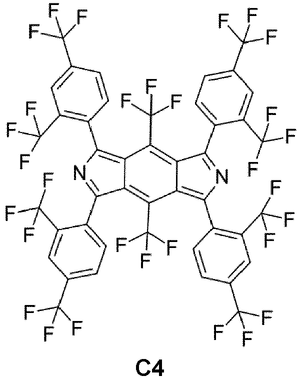

To a mixture of compound **C3** (2.34 g, 2.05 mmol), cesium carbonate (6.67 g, 20.47 mmol), azobisisobutyronitrile (6.7 mg, 40.8 µmol) and sodium iodide (25.0 mg, 166.8 µmol) in benzotrifluoride (34 mL) was added sulfuryl chloride (0.50 mL, 0.84 g, 6.22 mmol) under an argon atmosphere. The mixture was stirred 2 days at 80 °C and then 1 day at 100 °C. The reaction mixture was allowed to cool to room temperature and the solids were filtered off and washed with benzotrifluoride (5 mL). Through the dark green solution was bubbled dry nitrogen over 3 days to remove the solvent. The material was subjected to high vacuum sublimation (1.5 × 10⁻⁶ mbar, 190 °C) to obtain compound **C4** (373.0 mg, 327.6 µmol, 16 %) as a greenish black solid.

**APCI-MS:** m/z = 1138.9 [M+H]⁺

### N-Side measurements

### Sample preparation and conductivity measurement :

All layer were fabricated by thermal evaporation at room temperature under ultrahigh vacuum conditions (base pressure <5 × 10-7 mbar) by controlling the evaporation rates with quartz crystal microbalances (QCMs). 1 nm Cr and 50 nm Au were deposited through a shadow mask on a glass substrate to form interdigitated electrode patterns with 200-500 µm channel length. To prepare 30 nm thick doped layers with a specific doping ratio, a n-dopant was co-evaporated with an electron transport material (ETM), while the individual deposition rates were controlled with independent QCMs. These films were covered with 50 nm of intrinsic host material in order to provide a quick encapsulation from residual gases in the nitrogen glovebox used for characterization and encapsulation. This cover layer was found to increase the total lateral current between electrodes by less than 10%. Lateral conductivity was determined from current-voltage characteristics (-10 V to 10 V) using a source-measure unit, either directly in the glovebox or in air after encapsulation of the samples with cavity glasses and getter.

### Thermal properties:

| | **C7** |
|---|---|
| T_evap (0.3 Å/s, <5E-7 mbar, MTC) | 210°C |
| T_decomp (DSC) | >300°C |

### Conductivities:

| ETM | n-Dopant | Dopant concentration (wt%) | Conductivity doped film (S/cm) |
|---|---|---|---|
| C60 | None | - | 6E-5 |
| | **C7** | 2 | 6,5E-4 |
| | **C7** | 10 | 5,2E-3 |
| | **C7** | 20 | 2,7E-2 |

C60 [CAS 99685-96-8] is a fullerene compound and widely used as electron transport material in organic solar cell application.

### P-Side Measurements

To determine the evaporation temperature, 15 mg of the material was filled in an aluminum oxide crucible of a point source and heated in a vacuum chamber (base pressure <5 × 10⁻⁷ mbar) at 5 K/min until an evaporation rate of 0.3 Å/s is reached. The evaporation rate is monitored with a quartz crystal microbalance (QCM). The rate is kept constant for 10 min by controlling the heating and the evaporation temperature is determined by measuring the temperature at the bottom of the crucible with a thermocouple.

To achieve stable evaporation rates and to avoid cross contamination in mass production of organic electronic devices, such as organic solar cells, it is advantageous to use materials with a high evaporation temperature of at least above 120°C.

For the measurement of the lateral conductivity, a transmission line method was used. Interdigitated ITO (indium tin oxide) electrodes were formed by photolithography on a glass substrate with four different channel lengths (40 µm, 80 µm, 120 µm, 160 µm). Then organic layers were deposited by thermal evaporation under ultrahigh vacuum conditions (base pressure <5 × 10⁻⁷ mbar) by controlling the evaporation rates with quartz crystal microbalances (QCMs). First, a 10 nm thick p-doped layer was prepared by coevaporation of the p-dopant and the semiconductor matrix material. To obtain a specific dopant concentration, the individual deposition rates were controlled with independent QCMs. These films were covered with 100 nm of intrinsic semiconductor matrix material (common hole-injection layer + common hole-transport layer). Samples were encapsulated with glass lid and getter material under nitrogen atmosphere and characterized ex-situ at room temperature. Current-voltage characteristics (-10 V to 10 V) were measured using a source-measure unit Keithley 2400 and the lateral conductivity was determined from the slope of the resistance vs. channel length plot and by normalizing to the thickness of the p-doped layer, accounting for almost the entire current.

Compound C4 was found to have an evaporation temperature of 161°C at 0.3 Å/s, when determined as described above. This temperature is well suited for mass production of electronic components, such as organic solar cells. Dynamic scanning calorimetry (DSC) was conducted in a Mettler Toledo DSC3 with an Aluminum crucible weighing in 2 mg of analyte at a heating rate of 5K / min between RT and 400°C under a nitrogen atmosphere. For compound C4. The exothermic decomposition onset was >250°C. The thermostability gap of more than 20 K, i.e. the difference between the evaporation temperature at 0.3 Å/s, when determined as described above, and the onset of decomposition as measured with DSC of more than 20 K, is advantageous for mass production.

As semiconductor matrix material, HT-1 (N-([1,1'-Biphenyl]-4-yl)-9,9-dimethyl-N-(4-(9-phenyl-9H-carbazol-3-yl)phenyl)-9H-fluoren-2-amine ) and HT-2 (N-(9,9-Diphenyl-9H-fluoren-2-yl)-N,9-diphenyl-9H-carbazol-3-amine ) were used. HT-1 and HT-2 have a HOMO level of about -5.15 eV and -5.08 eV, respectively, wherein the HOMO level is measured by cyclic voltammetry as described herein. Hole transport materials with a shallow HOMO > -5.2 eV, when determined by cyclic voltammetry as described herein, are typically used in organic electronic devices to ensure a good energy level alignment with the anode.

The HOMO level was determined by cyclic voltammetry measured with a platinum working and counter electrode, an Ag/AgCI reference electrode and Ferrocene/Ferrocenium as an internal standard and a scan rate of 0.1V/s. As electrolyte, acetonitrile with 0.1M tetrabutylammonium hexafluorophosphate was used. The HOMO level was calculated from E(HOMO) = -4.79 eV - E_{1/2}(oxidation vs. Fc/Fc+).

To optimize the electrical performance of an organic electronic component, particularly the voltage, it is beneficial that the conductivity of the doped semiconductor layer exceeds a certain value depending on the device structure and the application.

**Table 1**

| p-Dopant | HTM | Dopant concentration (vol%) | Lateral conductivity in S/cm |
|---|---|---|---|
| none | HT-1 | 0 | <1E-8 |
| C4 | HT-1 | 2 | 3.26E-06 |
| C4 | HT-1 | 8 | 8.62E-06 |
| none | HT-2 | 0 | <1E-8 |
| C4 | HT-2 | 2 | 1.31E-06 |
| C4 | HT-2 | 8 | 4.30E-06 |

Table 1 shows that the conductivities of both HT-1 and HT-2 doped with C4 increase with increasing dopant concentration and are significantly higher than for the undoped layers. This proves that C4 can advantageously be used as a p-dopant. The conductivities of both HT-1 and HT-2 obtained at 2 vol% and 8 vol% doping with C4 are above 1E-6 S/cm, and therefore, C4 should be suitable for use in OLEDs or organic solar cells.

## Claims

1. A light-harvesting component, preferably an organic photovoltaic component or an organic photoactive sensor, comprising
• A first substrate, an electrode, a counterelectrode, and an organic layer system positioned between the electrode and the counterelectrode comprising at least a first photoactive layer,
• Wherein the organic layer system comprises at least a first charge carrier transport layer, wherein the first charge carrier transport layer comprises a first charge carrier transport matrix material and at least a concentration of 0.1 vol.%, preferably at least 0.5 vol.%, of **a first dopant,** wherein the first dopant is an anti-aromatic compound.

2. The light harvesting component according to claim 1, wherein the first charge carrier transport layer is a first electron transport layer and the first charge carrier transport matrix material is a first electron transport matrix material and the first dopant is a **first n-dopant.**

3. The light-harvesting component according to claim 2, wherein the **n-dopant** is a compound according to formula (I) 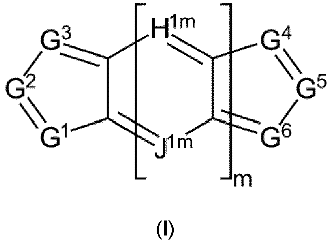
or their radical cations, radical cation salts, dications, dicationic salts or their charge transfer complexes with acceptors,
in which
m is 0, 1, 2, 3
G²,G⁵ are nitrogen, carbon-electron donating group, carbon-electron withdrawing group, or carbon-hydrogen,
G¹, G³, G⁴, G⁶, H^{1m}, J^{1m} are carbon-electron donating group, carbon-electron withdrawing group, or carbon-hydrogen.

4. The light-harvesting component according to claim 2 or 3, wherein the n-dopant is a compound according to formula (I.1) 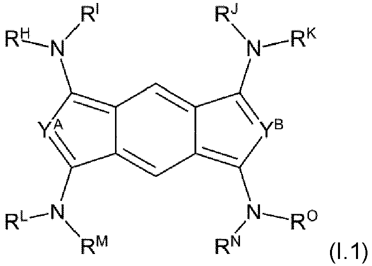
or their radical cations, radical cation salts, dications, dication salts, or their charge transfer complexes with donors,
in which
Y^{A} is selected from C-H, nitrogen (N), and C-R^{P},
Y^{B} is selected from C-H, nitrogen (N), and C-R^{Q}, and
wherein in compounds of formula (X) each of R^{H}, R^{I}, R^{J}, R^{K}, R^{L}, R^{M}, R^{N}, RO, R^{P}, R^{Q} are independently selected from
• C₁-C₆-alkyl, C₁-C₆-haloalkyl, C₃-C₁₀ Cycloalkyl,
• C₆-C₁₄-aryl or heteroaryl,
wherein heteroaryl has 4 to 13 carbon atoms,
wherein heteroaryl has 1, 2 or 3 identical or different heteroatoms or heteroatom-containing groups as ring members, selected from N, O, S, SO and SO₂,
wherein C₆-C₁₄-aryl and heteroaryl are unsubstituted or substituted by 1, 2, 3, 4 or 5 identical or different radicals R^{R};
wherein R^{R} represents CN, F, Cl, CF₃, OCF₃, SCF₃, SF₅, SO₂CF₃, C₁-C₄-alkyl, C₁-C₄-haloalkyl, C₁-C₆-alkoxy or C₆-C₁₄-aryl, which is unsubstituted or substituted by 1, 2 or 3 identical or
different radicals selected from F, CF₃, CN, C₁-C₄-alkyl and C₁-C₄-haloalkyl.

5. The light-harvesting component according to one of the claims 2 to 4, wherein the electron transport matrix material is selected from a material showing an acceptor level between -5.0 to -3.3 eV.

6. The light harvesting component according to claim 1, wherein the first charge carrier transport layer is a first hole transport layer and the charge carrier transport matrix material is a first hole transport matrix material and the first dopant is a **first p-dopant.**

7. The light-harvesting component according to claim 6, wherein **the first p-dopant** is a compound according to formula (II) 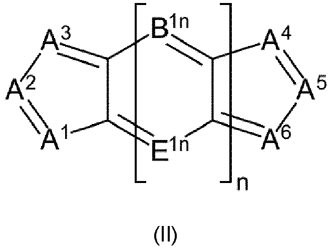
Or their radical anions, radical anion salts, dianions, dianionic salts or their charge transfer complexes with donors,
in which
n is 0, 1, 2, 3
A², A⁵ are nitrogen, carbon-electron withdrawing group or carbon-hydrogen,
A¹, A³, A⁴, A⁶, are N or carbon-electron withdrawing group or carbon-hydrogen,
B¹ⁿ, E^{1n are} nitrogen, carbon-electron withdrawing group, or carbon-hydrogen.

8. The light-harvesting component according to claim 6, wherein the first p-dopant is a compound according to formula (II.1): 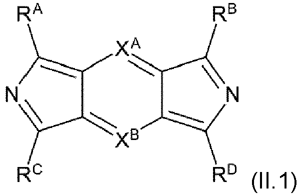
or their radical anions, radical anionic salts, dianions, dianionic salts, or their charge transfer complexes with donors,
in which
X^{A} is selected from C-H, nitrogen , C-CF₃, C-Cl, C-Br, and C-R^{E},
X^{B} is selected from C-H, nitrogen, C-CF₃, C-Cl, C-Br, and C-R^{F}, and
wherein in compounds of formula (II.1) R^{A}, R^{B}, R^{C}, R^{D}, R^{E}, and R^{F} are independently selected from C₆-C₁₄-aryl or heteroaryl,
wherein heteroaryl has 4 to 13 carbon atoms,
wherein heteroaryl has 1, 2 or 3 identical or different heteroatoms or heteroatom-containing groups as ring members, selected from N, O, S, SO and SO₂, wherein C₆-C₁₄-aryl and heteroaryl are unsubstituted or substituted by 1, 2, 3, 4 or 5 identical or different radicals R^{G};
wherein R^{G} is selected from CN, F, Cl, CF₃, OCF₃, SCF₃, SF₅, SO₂CF₃, C₁-C₄-alkyl, C₁-C₄-haloalkyl, C₁-C₄-haloalkylaryl or C₆-C₁₄-aryl, which is unsubstituted or substituted by 1, 2 or 3 identical or different radicals selected from F, CN, C₁-C₄-alkyl and C₁-C₄-haloalkyl.

9. The light harvesting component according to one of the claims 1 to 8, comprising a first electron transport layer according to one of the claims 2 to 4 comprising the **first n-dopant** according to one of the claims 2 to 4 and a first hole transport layer according to one of the claims 5 to 7 comprising a first p-dopant according to one of the claims 5 to 7.

10. The light-harvesting component according to one of the claims 1 to 9, further comprising at least a second hole transport layer, wherein the second hole transport layer comprises at least a concentration of 0.1 vol.%, preferably at least 1.0 vol.%, more preferably at least 5.0 vol.%, of **a second p-dopant,** wherein the second p-dopant is a compound according to formula (III):
Ce⁴⁺( L₁L₂L₃L₄⁻)₄ (III)
or mixtures thereof, wherein
L₁; L₂; L₃; and L₄ are independently from each other selected from a bidentate ligand comprising at least two cabon atoms, preferably at least eight carbon atoms.

11. The light-harvesting component according to claim 10, wherein the p-dopant is a compound wherein the p-dopant is a compound according to formula (III.1)
Ce⁴⁺(L₁L₂L₃L₄)⁴⁻ (III.1)
or mixtures thereof, wherein
L₁; L₂; L₃ ; and L₄ are independently from each other selected from a bidentate ligand having the general formula (IV) 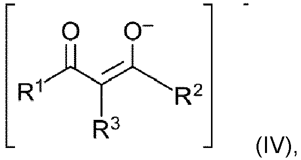 wherein
R¹, R², R³ independently from each other represent CN, C₁-C₆-alkyl, C₁-C₆-haloalkyl, C₆-C₁₄-aryl or hetaryl having 4 to 13 carbon atoms, wherein hetaryl has 1, 2 or 3 identical or different heteroatoms or heteroatom-containing groups as ring members, selected from N, O, S, SO and SO₂, wherein aryl and hetaryl are unsubstituted or substituted by 1, 2, 3, 4 or 5 identical or different radicals R⁴;
R⁴ represents CN, halogen, C₁-C₄-alkyl, C₁-C₄-haloalkyl or C₆-C₁₄-aryl, which is unsubstituted or substituted by 1, 2 or 3 identical or different radicals selected from C₁-C₄-alkyl,C₁-C₄-haloalkyl, OCF₃, SCF₃, SF₅, SO₂CF₃.

12. The light-harvesting component according to one of the claims 5 to 11, wherein the **hole transport matrix material** is selected from a material showing a donor level between -4.0 to -6.5 eV.

13. The light-harvesting component according to one of the claims 1 to 12, further comprising at least a second photoactive layer and at least a first charge recombination layer, wherein the first charge recombination layer is arranged between the first photoactive layer and the second photoactive layer.

14. The light-harvesting component according to one of the claims 1 to 12, wherein the first substrate comprises or consists of a glass.

15. An **electricity generating window** comprising a light-harvesting component according to one of the claims 1 to 13, a first transparent substrate and a second transparent substrate, wherein the electrode, the counterelectrode and the organic layer system are positioned between the first transparent substrate and the second transparent substrate.

16. **Use** of the light harvesting component, preferably of the organic photovoltaic component, according to one of the claims 1 to 14 for the production of an electricity generating window.
